# EUROPEAN PATENT APPLICATION

(11) **EP 4 641 243 A1**
(43) Date of publication of application: **29.10.2025**
(21) Application number: 24862972.7
(22) Date of filing: 21.06.2024
(51) Int. Cl.: G01R 35/00, G01R 19/00, G01R 27/02, G01R 19/165, G01R 31/36, G01R 1/20, B60R 16/033, B60L 58/10

(54) **BATTERY MODULE AND METHOD FOR DETERMINING STATE OF CURRENT SENSOR THEREOF**

(30) Priority: 07.09.2023 KR 20230118864
(71) Applicant: LG Energy Solution, Ltd., Seoul 07335 (KR)
(72) Inventor: PARK, Myeong Hui, Daejeon 34122 (KR)
(74) Representative: Plasseraud IP
(86) International application number: PCT/KR2024/008587
(87) International publication number: WO 2025/053389

(57) **Abstract**

According to an embodiment of the present disclosure, a battery module of an electronic device may comprise: a battery pack; a current sensor including a current detection resistor electrically connected to a current path formed by the battery pack; and a battery controller configured to control the battery pack and determine whether the current sensor is abnormal, on the basis of a measurement result of the current sensor, wherein one end of the current detection resistor is connected to the battery pack and the other end of the current detection resistor is connected to a ground line of the battery controller.

## Description

### Technical Field

The present disclosure relates to a battery module and technology for determining a state of a current sensor included in the battery module, and specifically, relates to technology for detecting a short-circuit state of a current sensor that includes a current detecting resistor (for example, a shunt resistor).

### Background Art

In general, two current sensors can be used to evaluate the validity of the battery pack's current. In this case, current sensor is connected to each terminal of the battery pack (in other words, the cathode terminal and the anode terminal), and the current validity of the battery pack is evaluated using the difference in the measurement results of the two current sensors. However, the method of using two current sensors is costly, and there may be a problem that it is difficult to miniaturize the size of the battery module.

### Detailed Description of the Invention

### Technical Goals

According to an example embodiment of the present disclosure, the technical challenge is to simply and accurately determine whether the current sensor is abnormal while determining the validity of the battery pack's current through one current sensor.

According to an example embodiment of the present disclosure, the technical challenge is to determine whether the current sensor is abnormal by measuring the consumption current of the battery management system (BMS).

### Technical solutions

A battery module according to an example embodiment of the present disclosure includes: a battery pack; a current sensor including a current detecting resistor electrically connected to a current path formed by the battery pack; and a battery controller configured to control the battery pack and determine whether the current sensor is abnormal, based on a measurement result of the current sensor, wherein the current detecting resistor has one end that is connected to the battery pack and the current detecting resistor has another end that is connected to a ground line of the battery controller.

The battery controller according to an example embodiment may be configured to determine that the current sensor is in an abnormal state in response that the measurement result of the current sensor is equal to or below a threshold value.

The battery module according to an example embodiment, wherein the battery controller may be configured to notify a vehicle controller of the abnormal state of the current sensor in response to a determination that the current sensor is in the abnormal state.

The battery controller according to an example embodiment may be configured to control a relay to open at least a part of the current path of the batty pack in response to the determination that the current sensor is in the abnormal state.

The threshold value according to an example embodiment may be determined based on a consumption current of the battery controller.

According to an example embodiment, an expected consumption current range of the battery controller may be set for each operation mode of the battery pack.

The battery controller according to an example embodiment may be configured to, based on the measurement result of the current sensor, determine an operation mode of the battery pack, identify an expected consumption current range of the battery controller corresponding to the operation mode of the battery pack, based on the identified expected consumption current range, correct the measurement result of the current sensor, and notify a vehicle controller of the corrected measurement result.

The battery controller according to an example embodiment may be configured to, in response that the measurement result of the current sensor exceeds the threshold value, determine that the current sensor is in a normal state, and in response to a determination that the current sensor is in the normal state, control the battery pack to supply power to a vehicle.

The battery controller according to an example embodiment may be configured to, by applying the measurement result of the current sensor to a SoX algorithm, obtain information on a battery state.

According to an example embodiment, the SoX algorithm may include at least one of a state of charge (SoC) algorithm, a state of power (SoP) algorithm and a state of health (SoH) algorithm, and the information on the battery state may include at least one of a battery SoC, a battery SoH and a battery SoP.

According to an example embodiment, the current detecting resistor may be a shunt resistor.

The battery controller according to an example embodiment may be configured to, before supplying a large amount of power to a motor of the vehicle, control a relay in order for the current path of the battery pack to form a closed circuit, and while the motor of the vehicle is not running, determine a state of the current sensor based on the measurement result of the current sensor.

A method of determining a state of a current sensor by a battery controller included in a battery module according to an example embodiment, the method including receiving a measurement result of a current sensor including a current detecting resistor electrically connected to a current path that formed by a battery pack, and based on the measurement result of the current sensor, determining whether the current sensor is abnormal, wherein the current detecting resistor has one end that is connected to the battery pack and the current detecting resistor has another end that is connected to a ground line of the battery controller.

### Effects of the Invention

According to the example embodiments, it is possible that while the validity of the current of a battery pack being determined through one current sensor, whether the current sensor is abnormal is determined simply and accurately.

According to the example embodiments, it is possible that whether the current sensor is abnormal is determined by measuring the consumption of the BMS.

### Brief Description of Drawings

FIG. 1 is a block diagram of a battery module according to an example embodiment of the present disclosure.
FIGS. 2a and 2b are diagrams illustrating a battery module according to an example embodiment of the present disclosure.
FIG. 3 is a processing flow diagram of a battery module according to an example embodiment of the present disclosure.
FIG. 4 is a processing flow diagram of a battery module according to an example embodiment of the present disclosure.
FIG. 5 is a processing flow diagram of a battery module according to an example embodiment of the present disclosure.
FIG. 6 is a processing flow diagram of a battery module according to an example embodiment of the present disclosure.

### Mode for Carrying Out the Invention

Terms used in the example embodiments are selected from currently widely used general terms when possible while considering the functions in the present disclosure. However, the terms may vary depending on the intention or precedent of a person skilled in the art, the emergence of new technology, and the like. Further, in certain cases, there are also terms arbitrarily selected by the applicant, and in the cases, the meaning will be described in detail in the corresponding descriptions. Therefore, the terms used in the present disclosure should be defined based on the meaning of the terms and the contents of the present disclosure, rather than the simple names of the terms.

Throughout the specification, when a part is described as "comprising or including" a component, it does not exclude another component but may further include another component unless otherwise stated. Furthermore, terms such as "... unit," "... group," and "... module" described in the specification mean a unit that processes at least one function or operation, which may be implemented as hardware, software, or a combination thereof.

Expression "at least one of a, b and c" described throughout the specification may include "a alone," "b alone," "c alone," "a and b," "a and c," "b and c" or "all of a, b and c."

Hereinafter, example embodiments of the present disclosure will be described in detail with reference to the accompanying drawings so that those of ordinary skill in the art to which the present disclosure pertains may easily implement them. However, the present disclosure may be implemented in multiple different forms and is not limited to the example embodiments described herein.

Hereinafter, example embodiments of the present disclosure will be described in detail with reference to the accompanying drawings.

In describing the example embodiments, descriptions of technical contents that are well known in the technical field to which the present disclosure pertains and that are not directly related to the present disclosure will be omitted. This is to more clearly convey the gist of the present disclosure without obscuring the gist of the present disclosure by omitting unnecessary description.

For the same reason, some elements are exaggerated, omitted or schematically illustrated in the accompanying drawings. In addition, the size of each element does not fully reflect the actual size. In each figure, the same or corresponding elements are assigned the same reference numerals.

Advantages and features of the present disclosure, and a method of achieving the advantages and the features will become apparent with reference to the example embodiments described below in detail together with the accompanying drawings. However, the present disclosure is not limited to the example embodiments disclosed below, and may be implemented in various different forms. The example embodiments are provided only so as to render the present disclosure complete, and completely inform the scope of the present disclosure to those of ordinary skill in the art to which the present disclosure pertains. The present disclosure is only defined by the scope of the claims. Like reference numerals refer to like elements throughout.

It will be understood that each block of a flowchart diagram and a combination of the flowchart diagrams may be performed by computer program instructions. The computer program instructions may be embodied in a processor of a general-purpose computer or a special purpose computer, or may be embodied in a processor of other programmable data processing equipment. Thus, the instructions, executed via a processor of a computer or other programmable data processing equipment, may generate a part for performing functions described in the flowchart blocks. To implement a function in a particular manner, the computer program instructions may also be stored in a computer-usable or computer-readable memory that may direct a computer or other programmable data processing equipment. Thus, the instructions stored in the computer usable or computer readable memory may be produced as an article of manufacture containing an instruction part for performing the functions described in the flowchart blocks. The computer program instructions may be embodied in a computer or other programmable data processing equipment. Thus, a series of operations may be performed in a computer or other programmable data processing equipment to create a computer-executed process, and the computer or other programmable data processing equipment may provide steps for performing the functions described in the flowchart blocks.

Additionally, each block may represent a module, a segment, or a portion of code that includes one or more executable instructions for executing a specified logical function(s). It should also be noted that in some alternative implementations the functions recited in the blocks may occur out of order. For example, two blocks shown one after another may be performed substantially at the same time, or the blocks may sometimes be performed in the reverse order according to a corresponding function.

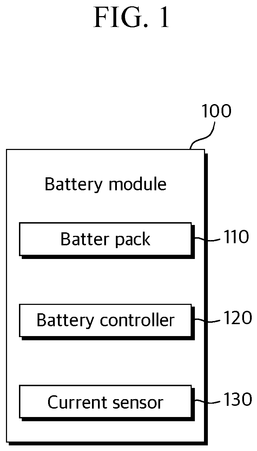

FIG. 1 is a block diagram of a battery module 100 according to an example embodiment of the present disclosure. In the present disclosure, as one module containing a battery pack 110 that stores electrical energy to power a vehicle (for example, an electric vehicle and a hybrid vehicle), a battery controller 120 for managing and controlling the battery pack 110 and necessary components required to supply other currents, the battery module 100 may also be called a battery system. In the present disclosure, the number of battery pack 110 included in the battery module 100 is shown as 1, but the invention is not limited thereto, and the battery module 100 may include two or more battery packs 110.

The battery module 100 according to an example embodiment may include the battery pack 110, the battery controller 120 and a current sensor 130. At least one of the components included in the battery module 100 may be omitted, or other components may be added to the battery module 100. Additionally or alternatively, some components may be implemented in an integrated manner, or may be implemented as singular or multiple entities. At least some of the components within the battery module 100 may be implemented in an integrated manner, or may be implemented as singular or multiple entities. At least some of the components within the battery module 100 may be interconnected via a controller area network (CAN), a bus, general purpose input/output (GPIO), a serial peripheral interface (SPI), or a mobile industry processor interface (MIPI), and may transmit and receive data and/or signals.

The battery pack 110 according to an example embodiment may include multiple battery modules connected in series. The number of battery modules included in the battery pack 110 may be two or more. Each battery module may include multiple battery cells connected in parallel. The number of battery cells contained in each battery module may be two or more. The battery pack 110 may perform a charging operation or a discharging operation by being connected to a load through the cathode terminal and anode terminal. A plurality of battery cells and a plurality of battery modules may be connected in parallel and series in various ways to meet the specifications of the power consuming device. The battery cell may be, for example, a lithium ion battery cell.

The battery pack 110 may be an electrical energy source that provides electrical energy to a power consuming device to power the power consuming device. The power consuming devices may include, for example, mobility devices such as electric vehicles, hybrid vehicles, and electric scooters. The battery pack 110 may supply power to a vehicle under the control of the battery controller 120, and may also be powered from a charging device.

The battery controller 120 according to an example embodiment may be a battery management system (BMS) that manages and controls the battery pack 110. The battery controller 120 may be called a BMS, a battery control circuit or a battery monitoring integrated circuit. The battery controller 120 is connected to the battery pack 110 and may obtain voltage signals measured from both ends of the battery pack 110. For example, the battery controller 120 may be connected to each of multiple battery modules included in the battery pack 110.

According to example embodiment, the current sensor 130 may be a sensor including a current detecting resistor. The current detecting resistor may be, for example, a shunt resistor. In other words, the current sensor 130 is a current sensor 130 that includes a shunt resistor and a high-speed amplifier, and has the advantages of being simple to install in the current path and easy to handle. According to an example embodiment, the current sensor 130 including the shunt resistor may measure the total current value flowing through the current sensor 130 by connecting the shunt resistors in parallel to a constant current circuit (an ammeter). In other words, the current measurement range may be expanded by using the current sensor 130 with shunt resistors connected in parallel. According to another example embodiment, the current sensor 130 including shunt resistors may detect the voltage drop across both terminals of the shunt resistor by connecting the shunt resistors in series with the ammeter, and the current sensor 130, which includes a shunt resistor, may also be used to measure the current flowing in the circuit. The battery controller 120 may measure the current of the battery pack 110 by converting the voltage measured by the current sensor 130 using a shunt resistor into current. In other words, since the resistance value of the shunt resistor is known in advance, when the voltage values at both ends of the shunt resistor are measured, the current sensor 130 may calculate the current value flowing through the shunt resistor, and this current value may be said to be the current value flowing in a charge/discharge path of the battery pack 110. The method of measuring current value is based on Ohm's law, and the exact current value may be measured by using the law that voltage changes proportionally to current.

According to an example embodiment, the current sensor 130 including a current detecting resistor may be electrically connected to a current path formed by the battery pack 110. For example, the current sensor 130 may be installed on the current path connected to the anode terminal (or, (-) terminal) among the two terminals of the battery pack 110. The current sensor 130 is connected to the battery controller 120 and may transmit a measurement result to the battery controller 120.

According to an example embodiment, the battery controller 120 may control or manage the battery pack 110. The battery controller 120 may monitor the voltage, current and temperature of the battery pack 110. The battery controller 120 may perform abnormal diagnosis, cell balancing, and estimating a state of charge (SoC), a state of health (SoH) and a state of power (SoP) of the battery pack 110. The SoC is a percentage expression of the current charge state of the battery, and the SoH is a percentage expression of the current degradation state of the battery, and the SoP is a ratio that expresses the current power state of the battery. The battery controller 120 may receive a measurement result from the current sensor 130, and based on the measurement result, the current state of the battery pack 110 may be detected. The battery controller 120 may also detect the state of the current sensor 130 based on the measurement result of the current sensor 130. This document discloses a specific method for the battery controller 120 to detect the state of the current sensor 130.

The battery module 100 according to an example embodiment may further include a relay (not illustrated). The relay may, under the control of the battery controller 120, open at least a part of the current path of the battery pack 110 to prevent current from flowing, and may also be used to connect the current path of the battery pack 110 to form a closed circuit.

The battery controller 120 according to an example embodiment may transmit information about the battery pack 110 to a vehicle controller (not illustrated). The vehicle controller may be, for example, an electronic control unit (ECU). A vehicle controller may refer to a control device that controls various states of a vehicle. The battery controller 120 may include a communication module for communicating with other systems within the vehicle (for example, a vehicle controller). The communication module of the battery controller 120 may communicate with other systems in the vehicle using a controller area network (CAN). Components within the battery controller 120 may also be connected to each other through a CAN bus. The CAN communication refers to a standard communication standard designed to allow controllers or devices to communicate with each other in a vehicle without a host computer. As a non-host bus message-based network protocol mainly used for communication between each controller, the CAN communication may be mainly used in vehicles. The communication module of the battery controller 120 may include a buffer that temporarily stores data received from other modules or systems.

For example, the battery controller 120 according to an example embodiment may notify information about the battery pack 110, including voltage, current, temperature, a SoC, a SoH, and a SoP of the battery pack 110, to the vehicle controller. The battery controller 120 may notify the state of components included in the battery module 100. For example, when an abnormal state of the battery pack 110 is detected, the battery controller 120 may notify the vehicle controller of the abnormal state of the battery pack 110. For example, when the battery controller 120 detects an abnormal state of the current sensor 130, the battery controller 120 may notify the vehicle controller of the abnormal state of the current sensor 130.

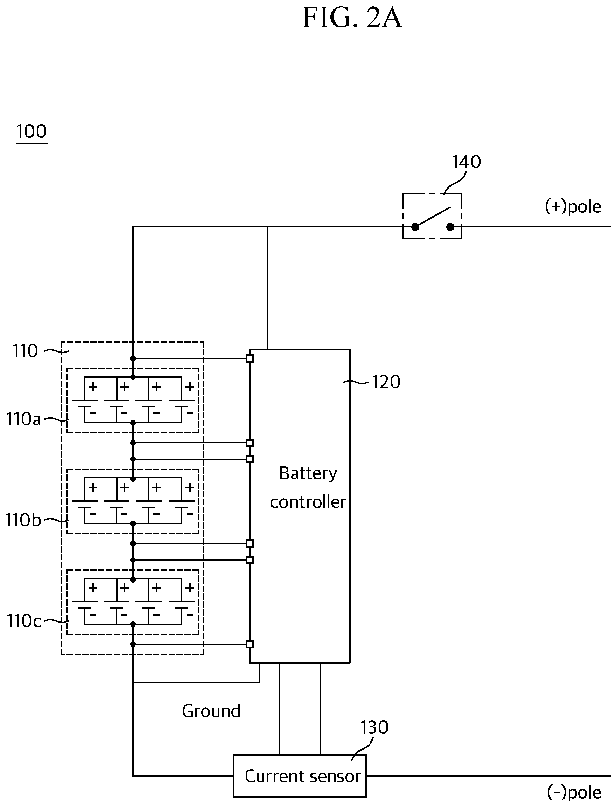

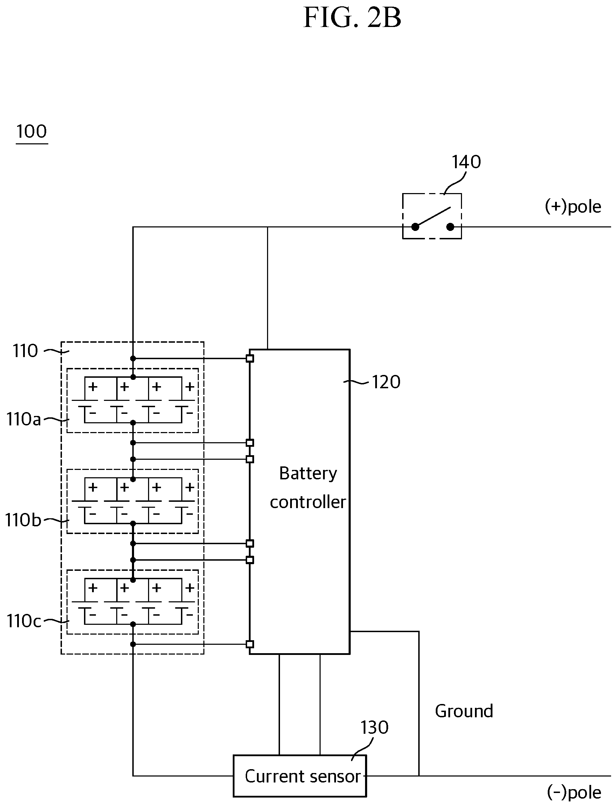

FIGS. 2a and 2b are diagrams illustrating the battery module 100 according to an example embodiment of the present disclosure.

FIG. 2a relates to an example embodiment in which the ground line of the battery controller 120 is directly connected to the anode terminal of the battery pack 110, FIG. 2b relates to an example embodiment in which the ground line of the battery controller 120 is installed in a path including the current detecting resistor of the current sensor 130. The battery module 100 illustrated in FIGS. 2a and 2b may include the battery pack 110, the battery controller 120, the current sensor 130 and a relay 140. The battery pack 110 may include a plurality of battery modules 110a, 110b and 110c. The plurality of battery modules 110a, 110b and 110c may be connected in series to each other. Each of the plurality of battery modules 110a, 110b and 110c may include a plurality of battery cells. The plurality of battery cells may be connected in parallel to each other.

Referring to FIG. 2a, with regard to the current sensor 130 according to an example embodiment, the current sensor 130 including a current detecting resistor may be electrically connected to the current path formed by the battery pack 110. The battery controller 120 is connected to the battery pack 110 and may monitor and estimate information about various states of the battery pack 110. The ground line of the battery controller 120 may be directly connected to the anode terminal of the battery pack 110. In other words, the ground line of the battery controller 120 may be connected between the anode terminal of the battery pack 110 and the current detecting resistor of the current sensor 130.

In other words, according to the example embodiment disclosed in FIG. 2a, the battery controller 120 may be directly connected to both ends (in other words, the cathode terminal and the anode terminal) of the battery pack 110, and monitor the state of the battery pack 110. In the case, the current sensor 130 may measure the current (or, charging/discharging current) coming out of or entering the battery pack 110. However, in the case, the current sensor 130 may not measure the current consumption of the battery controller 120 itself. For example, in the case, if a situation where the current detecting resistor of the current sensor 130 is shorted and the current value cannot be properly measured, the measured value of the current sensor 130 may be 0 A. Meanwhile, even if the battery pack 110 is in a state where it is not used (for example, the sleep mode), since the current does not flow from the battery pack 110, the measured value of the current sensor 130 may be 0 A.

Here, the consumption current of the battery controller 120 may refer to the current required for the battery controller 120 to operate. The consumption current of the battery controller 120 may be, for example, 100 to 200 mA. According to an example embodiment, the expected consumption current range of the battery controller 120 may be set for each operation mode of the battery pack 110. For example, when the battery pack 110 is in the sleep mode, the expected consumption current range of the battery controller 120 may be set to 100 to 200 mA, and when the battery pack 110 is in a discharge mode, the expected current consumption range of the battery controller 120 may be set to 200 to 300 mA. Therefore, if the detection result of the current sensor 130 is 110 mA, the current consumption of the battery controller 120 is 110 mA, and it may be determined that the current battery pack 110 is in the sleep mode. The described consumption current value is exemplary, and may change depending on the type of battery and type of vehicle apparently. The specific method of determining the operation mode will be described later.

In other words, in the example embodiment, if the measured value of the current sensor 130 is 0 A, it may simply be in a normal state in which the battery pack 110 is not used, or may be an abnormal state in which the current detecting resistor of the current sensor 130 is shorted. In the example embodiment, using only the measurement result of the current sensor 130, it cannot be clearly determined whether the current detecting resistor of the current sensor 130 is short-circuited. In the example embodiment, whether the current detecting resistor of the current sensor 130 is shorted may be determined only by combining measurement results of the current sensor 130, a battery cell voltage and external information.

Referring to FIG. 2b, the ground line of the battery controller 120 according to this embodiment is not directly connected to the anode terminal of the battery pack 110, but may be installed in the current path including the current detecting resistor of the current sensor 130. In other words, one end of the current detecting resistor may be connected to the battery pack 110, and the other end of the current detecting resistor may be connected to the ground line of the battery controller 120.

In other words, according to the example embodiment disclosed in FIG. 2b, since the battery controller 120 is connected to the path including the battery pack 110 and the current sensor 130, the current sensor 130 may measure the charging and discharging current of the battery pack 110 as well as the consumption current of the battery controller 120. In the case, the battery controller 120 may not only monitor the state of the battery pack 110, but also monitor the state of the current sensor 130. For example, in the example embodiment, when the battery pack 110 is in a state where it is not used (for example, the sleep mode), the current does not flow from the battery pack 110, but the battery controller 120 is in a normally operating state, and thus the measured value of the current sensor 130 may be the consumption current value of the battery controller 120 (for example, 100 to 200 mA). However, when the current detecting resistor of the current sensor 130 is shorted and the current value cannot be properly measured, the measured value of the current sensor 130 may be 0 A. In other words, the battery controller 120 according to the example embodiment may determine whether the current detecting resistor of the current sensor 130 is shorted using only the measurement result of the current sensor 130.

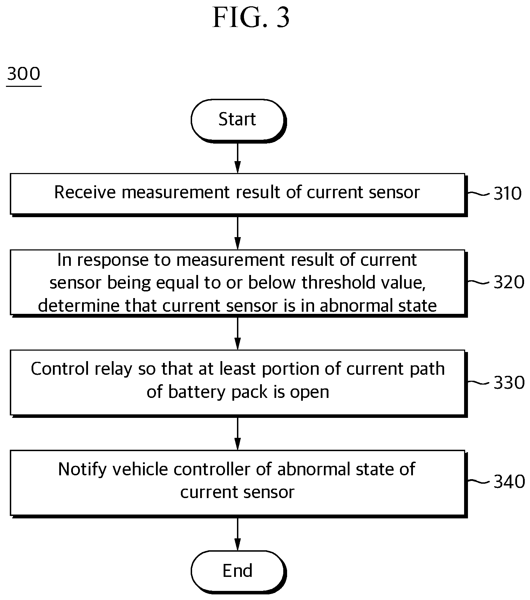

FIG. 3 is a processing flow diagram of the battery module 100 according to an example embodiment of the present disclosure.

Referring to a processing flow diagram 300, the battery controller 120 of the battery module 100 according to an example embodiment may receive a measurement result of the current sensor 130 in operation 310. The battery controller 120 may receive the measurement result regarding the current measured by the current sensor 130.

In operation 320, in response to the measurement result of the current sensor 130 being equal to or below a threshold value, the battery controller 120 of the battery module 100 according to an example embodiment may determine that the current sensor 130 is in an abnormal state. The threshold value is a value that is set to determine whether the current sensor 130 is abnormal, and may be determined based on the current consumption of the battery controller 120. For example, if the consumption current of the battery controller 120 is 120 mA, a user may determine the threshold to be 100 mA. The above figures are illustrative, and the figure may be set in various ways within the range by which whether the current sensor 130 is abnormal can be determined. If the measurement result of the current sensor 130 is equal to or below the threshold value, the battery controller 120 may determine an abnormal state in which the current sensor 130 cannot measure the consumption current of the battery controller 120, or the state in which the current detecting resistor of the current sensor 130 is shorted.

In operation 330, the battery controller 120 according to an example embodiment may control the relay so that at least a portion of the current path of the battery pack 110 is open. In response to the determination that the current sensor 130 is in an abnormal state, the battery controller 120 may control a relay (for example, the relay 140 in FIG. 2b) to open at least a portion of the current path of the battery pack 110. In other words, when it is determined that current sensor 130 is in an abnormal state, the battery controller 120 may open the current path to prevent the current from flowing in the battery pack 110. Through this, battery accidents may be prevented in advance.

In operation 340, the battery controller 120 according to an example embodiment may notify the vehicle controller of the abnormal state of the current sensor 130. When it is determined that the current sensor 130 is in an abnormal state, the battery controller 120 may notify the vehicle controller of the abnormal state of the current sensor 130. In other words, the battery controller 120 may notify the vehicle controller of the fact that there is a problem with the current sensor 130, so that immediate follow-up procedures may be performed.

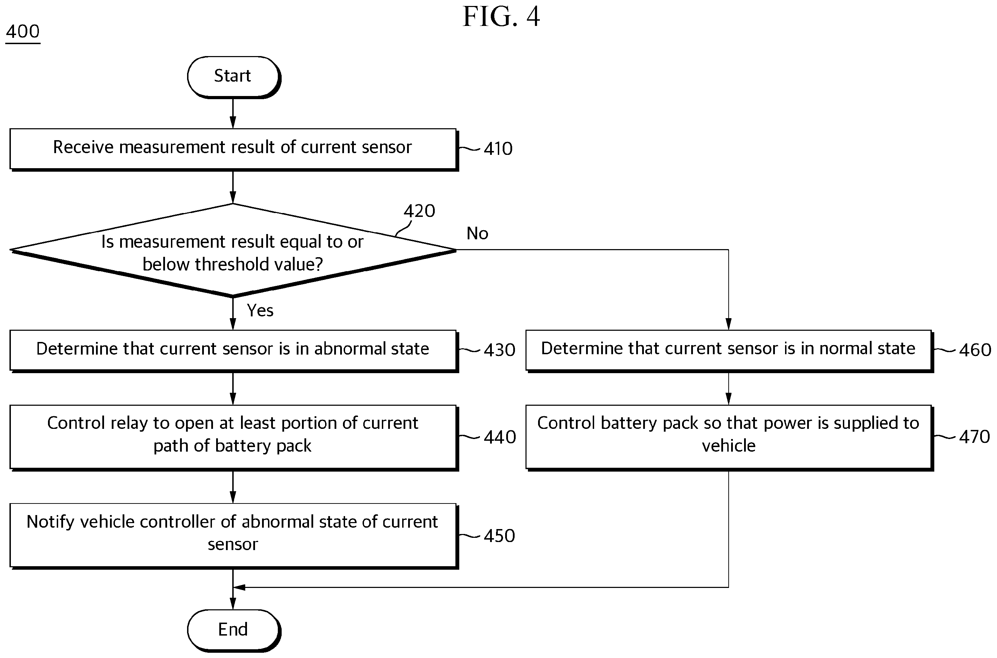

FIG. 4 is a processing flow diagram of the battery module 100 according to an example embodiment of the present disclosure. Content that overlaps the content described with respect to FIG. 3 will be omitted.

Referring to a processing flow diagram 400, the battery controller 120 of the battery module 100 according to an example embodiment may receive a measurement result of the current sensor 130 in operation 410. In operation 420, the battery controller 120 according to an example embodiment may compare the measurement result received from the current sensor 130 with a threshold value. The threshold value is a value that is set to determine whether the current sensor 130 is abnormal, and may be determined based on the current consumption of the battery controller 120.

If the measurement result is equal to or below the threshold value, the process branches to operation 430 (420 - Yes), the battery controller 120 according to an example embodiment may determine that the current sensor 130 is in an abnormal state. In response to the measurement result being equal to or below a threshold value, the battery controller 120 may determine the current sensor 130 is in the abnormal state in which the current detecting resistor of the current sensor 130 is short-circuited. In operation 440, the battery controller 120 according to an example embodiment may control the relay to open at least a portion of the current path of the battery pack 110 in response to determining that the current sensor 130 is in an abnormal state. In operation 450, in response to the determination that the current sensor 130 is in an abnormal state, the battery controller 120 according to an example embodiment may notify the vehicle controller of the abnormal state of the current sensor 130.

When the measurement result exceeds the threshold, the process branches to operation 460 (420-No), the battery controller 120 according to an example embodiment may determine that the current sensor 130 is in a normal state. In other words, the battery controller 120 may determine the measurement result of the current sensor 130 using a current consumption of the battery controller 120, and it may be determined that the current sensor 130 is in a normal state. In operation 470, in response to the determination that the current sensor 130 is in a normal state, the battery controller 120 according to an example embodiment may control the battery pack 110 so that power is supplied to the vehicle. In the case, when the required power corresponding to the required torque is requested from the vehicle controller, the battery controller 120 may control the battery pack 110 to output required power corresponding to the torque required for the motor of the vehicle.

Further, when the current sensor 130 is in the normal state, the battery controller 120 may obtain information about the battery state by applying the measurement result of the current sensor 130 to the SoX algorithm. For example, the SoX algorithm may include at least one of a SoC algorithm, a SoP algorithm and a SoH algorithm. Information about the battery state may include at least one of a battery SoC, a battery SoH and a battery SoP. The SoX algorithm may include a variety of known algorithms. For example, the battery controller 120 may obtain information about the battery SoC by applying the measurement result of the current sensor 130 to the SoC algorithm.

According to an example embodiment, before supplying a large amount of power to a motor of a vehicle, the battery controller 120 may control the relay in order for the current path of the battery pack 110 to form a closed circuit, and while the motor of the vehicle is not running, based on the measurement result of the current sensor 130, the battery controller 120 may determine the state of the current sensor 130. In other words, the battery controller 120 may form a closed circuit for power supply even before supplying a large amount of power to the motor of the vehicle, and determine the state of the current sensor 130 in advance before the motor is driven.

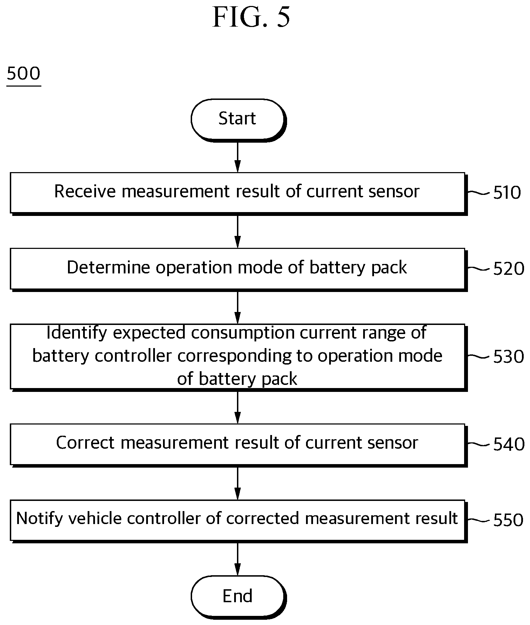

FIG. 5 is a processing flow diagram of the battery module 100 according to an example embodiment of the present disclosure.

Referring to a processing flow diagram 500, the battery controller 120 of the battery module 100 according to an example embodiment may receive a measurement result of the current sensor 130 in operation 510.

In operation 520, the battery controller 120 according to one example embodiment may determine the operation mode of the battery pack 110. For example, the operation mode of the battery pack 110 may include the sleep mode, the discharge mode and a charge mode. The sleep mode is a mode in which in a state where the vehicle does not start, there is no request from the vehicle to output power to the battery pack 110, and the sleep mode may indicate a mode in which the battery pack 110 does not operate. In other words, in the sleep mode, there is no current charging or discharging from the battery pack 110. Meanwhile, even when the battery pack 110 is in the sleep mode, monitoring of the battery pack 110 must be performed, and thus the battery controller 120 may operate, and the current consumption may occur accordingly.

The discharge mode is a mode in which power is output from the battery pack 110, and may indicate a mode in which while the vehicle is driving, in response to a request of a user, the vehicle controller requests the battery controller 120 to output the required power according to the required torque, and accordingly, the required power is output. In other words, in the discharge mode, the current discharging from the battery pack 110 and the consumption current used from the battery controller 120 may occur. The charge mode is a mode for charging the battery pack 110, and may indicate a mode in which the battery pack 110 is charged through an external charging device or the battery pack 110 is charged according to regenerative braking.

The battery controller 120 may determine the current operation mode of the battery pack 110. In other words, since the battery controller 120 monitors the battery pack 110 in real time, the battery controller 120 may know what the current operation mode of the battery pack 110 is.

In operation 530, the battery controller 120 according to an example embodiment may identify the expected consumption current range of the battery controller 120 corresponding to the operation mode of the battery pack 110. The consumption current of the battery controller 120 may vary depending on the operation mode of the battery pack 110. Therefore, the range of the expected consumption current of the battery controller 120 may be set for each operation mode of the battery pack 110. For example, when the battery pack 110 is in the sleep mode, the expected current consumption range of the battery controller 120 is set to 100 to 200 mA, when the battery pack 110 is in the discharge mode, the expected current consumption range of the battery controller 120 may be set to 200 to 300 mA, and when the battery pack 110 is in the charge mode, the expected current consumption range of the battery controller 120 may be set to 250 to 350 mA. For example, if the current operation mode of the battery pack 110 is the discharge mode, the battery controller 120 may identify that the consumption current is 200 to 300 mA. In example embodiments, it is explained that the range of expected consumption current is set, but it is apparent that the expected consumption current may be set to a specific value rather than a range.

In operation 540, the battery controller 120 according to an example embodiment may correct the measurement result of the current sensor 130. The battery controller 120 may correct the measurement result of the current sensor 130 by subtracting the identified expected consumption current from the measurement result of the current sensor 130. In other words, the pure charging/discharging current of the battery pack 110 that does not reflect the consumption current of the battery controller 120 may be calculated. In operation 550, the battery controller 120 according to an example embodiment may notify the vehicle controller of the corrected measurement result.

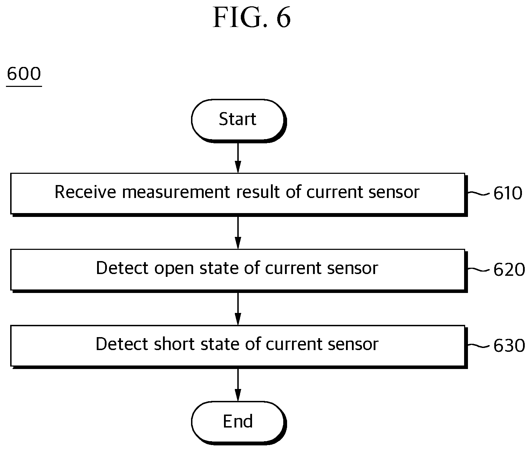

FIG. 6 is a processing flow diagram of the battery module 100 according to an example embodiment of the present disclosure.

Referring to a processing flow diagram 600, the battery controller 120 of the battery module 100 according to an example embodiment may receive the measurement result of the current sensor 130 in operation 610.

In operation 620, the battery controller 120 according to an example embodiment may detect the open state of the current sensor 130. In a situation where the voltage of a plurality of battery cells included in the battery pack 110 does not rise or fall suddenly, the battery controller 120 may determine whether the current detecting resistor of the current sensor 130 is open based on the detection result of the current sensor 130. When it is determined that the current sensor 130 is open, the battery controller 120 may determine that there is an abnormal state, and may control the relay so that at least some of the current path of the battery pack 110 is opened.

In operation 630, the battery controller 120 according to an example embodiment may detect a short state of the current sensor 130. Based on the measurement result of the current sensor 130, the battery controller 120 may determine whether the current detecting resistor of the current sensor 130 is shorted. The method for diagnosing the short state of the current sensor 130 is the same as the method described in FIGS. 3 and 4. If it is determined that the current sensor 130 is shorted, the battery controller 120 may determine that there is an abnormal state, and may control the relay so that at least some of the current path of the battery pack 110 is opened.

When it is determined that the current detecting resistor of the current sensor 130 is not open or shorted, the battery controller 120 may determine that the current sensor 130 is in a normal state, and control the battery pack 110 so that power is supplied to the vehicle in response to the required torque.

Meanwhile, in the present disclosure and drawings, example embodiments are disclosed, and certain terms are used. However, the terms are only used in general sense to easily describe the technical content of the present disclosure and to help the understanding of the present disclosure, but not to limit the scope of the present disclosure. It is apparent to those of ordinary skill in the art to which the present disclosure pertains that other modifications based on the technical spirit of the present disclosure may be implemented in addition to the example embodiments disclosed herein.

A device or a terminal according to the above described example embodiments may include a processor, a memory for storing and executing program data, permanent storage such as disk drives, communication ports to communicate with external devices and user interface devices such as touch panels, keys and buttons. Methods implemented as software modules or algorithms are computer readable codes or program instructions executable on the processor, and may be stored on a computer-readable recording medium. Here, the computer-readable recording medium includes a magnetic storage medium (for example, a read-only memory (ROM), a random-access memory (RAM), a floppy disk and a hard disk) and an optically readable medium (for example, a CD-ROM, a digital versatile disc (DVD)). The computer-readable recording medium may be distributed among network-connected computer systems, so that a computer-readable code may be stored and executed in a distributed manner. The medium may be readable by a computer, stored in a memory, and executed on a processor.

The example embodiments may be represented by functional block elements and various processing steps. The functional blocks may be implemented in any number of hardware and/or software configurations that perform specific functions. For example, an example embodiment may adopt integrated circuit configurations, such as memory, processing, logic and/or look-up table, that may execute various functions by the control of one or more microprocessors or other control devices. Similar to that elements may be implemented as software programming or software elements, the example embodiments may be implemented in a programming or scripting language such as C, C++, Java, assembler, Python, etc., including various algorithms implemented as a combination of data structures, processes, routines, or other programming constructs. Functional aspects may be implemented in an algorithm running on one or more processors. Further, the example embodiments may adopt the existing art for electronic environment setting, signal processing, and/or data processing. Terms such as "mechanism," "element," "means" and "configuration" may be used broadly and are not limited to mechanical and physical elements. The terms may include the meaning of a series of routines of software in association with a processor or the like.

The above-described example embodiments are merely examples, and other embodiments may be implemented within the scope of the claims to be described later.

## Claims

1. A battery module comprising:
a battery pack;
a current sensor comprising a current detecting resistor electrically connected to a current path formed by the battery pack; and
a battery controller configured to control the battery pack and determine whether the current sensor is abnormal, based on a measurement result of the current sensor,
wherein the current detecting resistor has one end that is connected to the battery pack and the current detecting resistor has another end that is connected to a ground line of the battery controller.

2. The battery module of claim 1, wherein the battery controller is configured to determine that the current sensor is in an abnormal state in response that the measurement result of the current sensor is equal to or below a threshold value.

3. The battery module of claim 2, wherein the battery controller is configured to notify a vehicle controller of the abnormal state of the current sensor in response to a determination that the current sensor is in the abnormal state.

4. The battery module of claim 2, wherein the battery controller is configured to control a relay to open at least a part of the current path of the batty pack in response to the determination that the current sensor is in the abnormal state.

5. The battery module of claim 2, wherein the threshold value is determined based on a consumption current of the battery controller.

6. The battery module of claim 2, wherein an expected consumption current range of the battery controller is set for each operation mode of the battery pack.

7. The battery module of claim 6, wherein the battery controller is configured to:
based on the measurement result of the current sensor, determine an operation mode of the battery pack;
identify an expected consumption current range of the battery controller corresponding to the operation mode of the battery pack;
based on the identified expected consumption current range, correct the measurement result of the current sensor; and
notify a vehicle controller of the corrected measurement result.

8. The battery module of claim 2, wherein the battery controller is configured to:
in response that the measurement result of the current sensor exceeds the threshold value, determine that the current sensor is in a normal state; and
in response to a determination that the current sensor is in the normal state, control the battery pack to supply power to a vehicle.

9. The battery module of claim 1, wherein the battery controller is configured to,
by applying the measurement result of the current sensor to the SoX algorithm, obtain information on a battery state.

10. The battery module of claim 9,
wherein the SoX algorithm comprises at least one of a state of charge (SoC) algorithm, a state of power (SoP) algorithm, and a state of health (SoH) algorithm,
wherein the information on the battery state comprises at least one of a battery SoC, a battery SoH and a battery SoP.

11. The battery module of claim 1, wherein the current detecting resistor is a shunt resistor.

12. The battery module of claim 1, wherein the battery controller is configured to:
before supplying a large amount of power to a motor of the vehicle, control a relay in order for a closed circuit to be formed in the current path of the battery pack; and
while the motor of the vehicle is not running, determine a state of the current sensor based on the measurement result of the current sensor.

13. A method of determining a state of a current sensor by a battery controller included in a battery module, the method comprising:
receiving a measurement result of a current sensor comprising a current detecting resistor electrically connected to a current path that formed by a battery pack; and
based on the measurement result of the current sensor, determining whether the current sensor is abnormal,
wherein the current detecting resistor has one end that is connected to the battery pack and the current detecting resistor has another end that is connected to a ground line of the battery controller.
